(19) Europäisches Patentamt
European Patent Office
Office européen des brevets

(11) **EP 1 261 138 B1**

(12) **EUROPÄISCHE PATENTSCHRIFT**

(45) Veröffentlichungstag und Bekanntmachung des Hinweises auf die Patenterteilung:
**24.01.2007 Patentblatt 2007/04**

(51) Int Cl.:
***H03M 7/06*** (2006.01)

(21) Anmeldenummer: **02100372.8**

(22) Anmeldetag: **15.04.2002**

(54) **Verfahren und Anordnung zur Duobinärcodierung einer Gruppe von Binärsignalen**

Method and arrangement for duobinary coding of a group of binary signals

Méthode et appareil pour codage duobinaire d' un groupe de signaux binaires

(84) Benannte Vertragsstaaten:
**DE FR GB IT**

(30) Priorität: **04.05.2001 DE 10121756**

(43) Veröffentlichungstag der Anmeldung:
**27.11.2002 Patentblatt 2002/48**

(73) Patentinhaber: **SIEMENS AKTIENGESELLSCHAFT 80333 München (DE)**

(72) Erfinder:
• **Rosenkranz, Werner Prof.-Dr. 24235, Laboe (DE)**
• **Wree, Christoph 24143, Kiel (DE)**

(56) Entgegenhaltungen:

• **MAY G ET AL: "EXTENDED 10 GB/S FIBER TRANSMISSION DISTANCE AT 1538 NM USING A DUOBINARY RECEIVER" IEEE PHOTONICS TECHNOLOGY LETTERS, IEEE INC. NEW YORK, US, Bd. 6, Nr. 5, 1. Mai 1994 (1994-05-01), Seiten 648-650, XP000446985 ISSN: 1041-1135**
• **ROYSET AND D HJELME A: "Novel dispersion tolerant optical duobinary transmitter using phase modulator and Bragg grating filter" PROCEEDINGS OF THE EUROPEAN CONFERENCE ON OPTICAL COMMUNICATION, XX, XX, 20. - 24. September 1998, Seiten 225-226, XP002185839 Madrid, Spain**
• **KOJI SASAYAMA ET AL: "COHERENT OPTICAL TRANSVERSAL FILTER USING SILICA-BASED WAVEGUIDES FOR HIGH-SPEED SIGNAL PROCESSING" JOURNAL OF LIGHTWAVE TECHNOLOGY, IEEE. NEW YORK, US, Bd. 9, Nr. 10, 1. Oktober 1991 (1991-10-01), Seiten 1225-1230, XP000241887 ISSN: 0733-8724**
• **ONO T ET AL: "CHARACTERISTICS OF OPTICAL DUOBINARY SIGNALS IN TERABIT/S CAPACITY, HIGH-SPECTRAL EFFICIENCY WDM SYSTEMS" JOURNAL OF LIGHTWAVE TECHNOLOGY, IEEE. NEW YORK, US, Bd. 16, Nr. 5, 1. Mai 1998 (1998-05-01), Seiten 788-797, XP000772641 ISSN: 0733-8724**
• **WREE C ET AL: "Upgrading of Nx40Gb/s WDM system from 100GHz to 50GHz channel spacing by duobinary interleaving concept with optical transversal filter" PROCEEDING 27TH EUROPEAN CONFERENCE ON OPTICAL COMMUNICATION, Bd. 4, 30. September 2001 (2001-09-30) - 4. Oktober 2001 (2001-10-04), Seiten 532-533, XP010582670 Amsterdam, Netherlands**
• **KIM HOON., YU CHARLES X., NEILSON DAVID T.: "Demonstration of Optical Duobinary Transmission System Using Phase Modulator and Optical Filter" IEEE PHOTONICS TECHNOLOGY LETTERS, Bd. 14, Nr. 7, Juli 2002 (2002-07), Seiten 1010-1012,**

**Beschreibung**

Die Erfindung betrifft ein Verfahren zur Duobinärcodierung nach dem Oberbegriff des Anspruchs 1.

Bei Übertragungssystemen wird die Duobinärcodierung vorteilhaft zur Verringerung der Übertragungsbandbreite bzw. zur Vergrößerung der Übertragungskapazität eingesetzt. Bei der Duobinärcodierung, ein Spezialfall der Partial-Response-Binärcodierung wird ein binäres Datensignal nach einer speziellen Codierungsregel in ein dreistufiges Signal umgesetzt. Der Bandbreitenbedarf dieses ternären Übertragungssignals wird gegenüber dem binären Datensignal hierdurch annähernd halbiert. Der ursprünglich zur Übertragung von elektrischen Signalen entwickelte Code wird wegen dieser Eigenschaften auch bei der Übertragung von optischen Signalen eingesetzt.

In der Zeitschrift "Journal of Lightwave Technology", Vol. 16, No. 5, May 1998, Seiten 788 bis 797, "Characteristics of Optical Duobinary Signals in Terabit/s Capacity, High-Spectral Efficiency WDM Systems", Takashi Ono et al. wird die Verwendung dieses Codes auch bei der optischen Signalübertragung erläutert. Die duobinären Signale werden in ein amplituden- und phasenmoduliertes optisches Übertragungssignal umgesetzt. Zwei duobinäre (ternäre)Werte werden durch einen hohen Signalpegel und zwei verschiedene Phasenlagen übertragen, bei einem dritten Wert ist kein oder nur ein geringer Pegel des Trägersignals vorhanden. Prinzipiell ist es auch möglich, andere Zustände zu übertragen, die jedoch bei optischen Systemen meist weniger vorteilhaft ist. Die Duobinärcodierung kann mit Hilfe eines Precoders und mindestens eines elektrischen Filters vorgenommen werden, woran sich eine Umsetzung in ein optisches Signal mit Hilfe eines optischen Modulators, beispielsweise eines Mach-Zehnder-Modulators, anschließt.

Aus Electronics Letters 18th January 2001, Vol. 37, No. 2, Seiten 109 bis 110 "320 Gbit/s WDM repeaterless transmission using fully encoded 40 Gbit/s optical duobinary channels with dispersion tolerance of 380 ps/nm" von K. Yonenaga et al. ist eine Anordnung zur Duobinärcodierung mit Hilfe eines Precoders und zweier elektrischer Tiefpaßfilter beschrieben, über die ein optischer Modulator angesteuert wird. Eine zufriedenstellende zweiseitige Ansteuerung des Modulators mit zwei identischen Signalen ist bei einer hohen Übertragungsrate von ca. 40 Gbit/s jedoch schwer zu realisieren. Außerdem hat eine elektrische Codierung des Signals zur Folge, dass das optische Signal nach dem nichtlinearen Mach-Zehnder-Modulator spektral verbreitert wird und daher die Bandbreiteneffizienz verringert. Die elektrischen Tiefpaßfilter sind für jeden Modulator erforderlich.

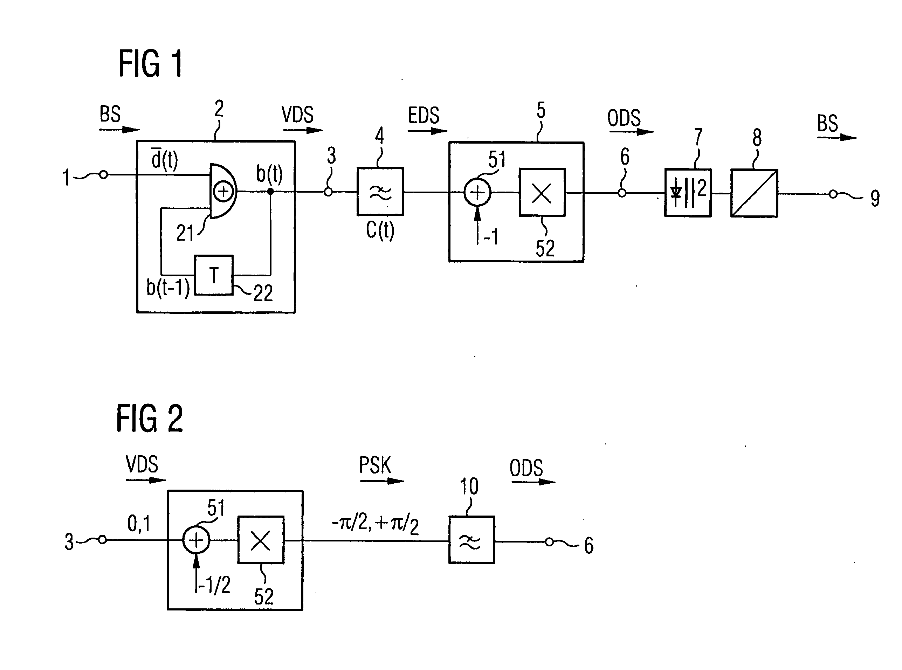

In dem Patent US 6,097,525 sind verschiedene Verfahren zur Duobinärcodierung beschrieben. Ein als Stand der Technik beschriebenes Verfahren verwendet eine in Figur 1 dargestellte Anordnung, die wiederum zwei Filter benötigt und einen zweiseitig angesteuerten Modulator. Bei der Beschriebenen Erfindung erfolgt die duobinäre Codierung mit Hilfe einer aus Precoder, Laufzeitglied, Intensitäts- und Phasenmodulator bestehenden Anordnung, die einen erheblichen Schaltungsaufwand darstellt.

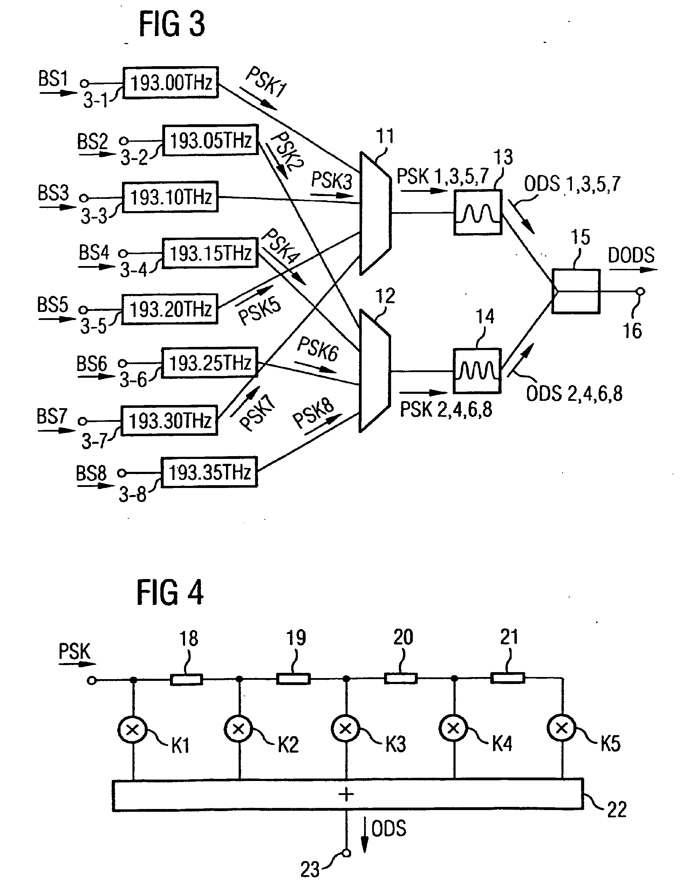

Aus der Offenlegungsschrift DE 199 26 124 A1 sind weitere Anordnungen zur Duobinärcodierung angegeben, die zwei Codierzweige mit entweder Precodern oder duobinären Filtern aufweisen und die Addition der vorcodierten Signale im Modulator durchführen. Bei einer in Figur 4 dargestellten Variante erfolgt die Codierung mit Hilfe eines Vorcodierers und eines Duobinärcoders, dem eine Filtereinheit nachgeschaltet ist.

Im Beitrag von May et al. "Extended 10 Gb/s Fiber Transmission Distance at 1538 nm Using a Duobinary Receiver" IEEE Photonics Technology Letters; 6 (1994)May, No. 5, Seiten 1994-650, New York ist die Realisierung eines Duobinar-Senders und -Empfängers kurz beschrieben. In beiden Fällen werden Precoder verwendet, wie auch der in Figur 1 dargestellte Empfänger zeigt.

Royset et al. beschreiben in "Novel Dispersion Tolerant Optical Duobinary Transmitter Using Phase Modulator and Bragg Grating Filter" in IEEE Photonics Technology Letters, ECOC 98, 20-24 September, Seiten 225, 226 ein in Figur 1 dargestelltes Übertragungssystem. Dieses enthält einen Phasenmodulator und ein Filter zur PSK-ASK-Umsetzung.

Aufgabe der Erfindung ist es, ein Verfahren und eine Anordnung zur Duobinärcodierung von Binärsignalen anzugeben.

Ein Verfahren zur Duobinärcodierung von Binärsignalen mit Hilfe eines optischen Filters ist in Anspruch 1 angegeben. Eine geeignete Anordnung zur Duobinärcodierung ist in einem unabhängigen Anspruch 5 angegeben.

Der Vorteil der Erfindung besteht zunächst in der Vermeidung der bei den herkömmlichen Codiereranordnungen auftretenden Spektrumsverbreiterung und Verschlechterung des Rauschabstandes.

Ein wesentlicher Vorteil der Codierung mit Hilfe von optischen Tiefpaßfiltern besteht aber darin, dass eine Codierung von mehreren Signalen (Kanälen) mit gleicher Datenrate auch gleichzeitig mit nur einem optischen Transversalfilter vorgenommen werden kann. Dies ist aufgrund der strengen Periodizität der optischen Filter im Frequenzbereich möglich. Wird diese so gewählt, dass sie dem Kanalabstand eines WDM-Systems entspricht, so kann durch eine simultane Duobinärcodierung der Signale eine erhebliche Aufwandseinsparung erreicht werden.

Besonders beim Aufbau von DWDM-Systemen (Dense) mit einem geringen Kanalabstand ist diese Codierung aufgrund der geringen benötigten Bandbreite besonders vorteilhaft. Die Gesamtzahl der Kanäle wird in zwei oder mehr Gruppen aufgeteilt, deren Mittenfrequenzen gegeneinander um jeweils einen halben Kanalabstand einer Gruppe (bei zwei Gruppen) verschoben sind.

Die Signale beider Kanalgruppen werden zunächst zu jeweils einem WDM-Signal zusammengefasst und dann duobinär codiert, was zu Kanälen mit geringer Bandbreite führt. Diese Kanalgruppen werden wiederum zu einem DWDM-Signal über einen Koppler zusammengefasst.

Vorteilhafte Weiterbildungen der Erfindung sind in abhängigen Ansprüchen beschrieben.

Ausführungsbeispiele der Erfindung werden anhand von Figuren näher erläutert. Es zeigen:

Figur 1 eine bekannte Anordnung zur Duobinärcodierung,

Figur 2 eine erfindungsgemäße Anordnung zur Duobinärcodierung,

Figur 3 eine Anordnung zur Erzeugung eines Wellenlängenmultiplexsignals,

Figur 4 ein optisches Transversalfilter,

Figur 5 die Übertragungsfunktion eines optischen Transversalfilters und

Figur 6 ein Augendiagramm dieses Filters.

**Figur 1** zeigt eine bekannte Anordnung zur Duobinärcodierung eines optischen Signals. Diese besteht aus der Reihenschaltung eines Precoders 2, dessen Dateneingang 1 ein (gegebenenfalls invertiertes) Binärsignal BS zugeführt wird, eines elektrischen Filters 4 und eines Phasenmodulators 5, an dessen Ausgang 4 ein optisches Duobinärsignal ODS abgegeben wird. Als Modulator 5 wird ein Mach-Zehnder-Modulator 52 mit einer Ansteuerschaltung 51 verwendet. Für die Erfindung unwesentliche Elemente sind nicht dargestellt.

Der Precoder 2, hier realisiert durch ein Exclusive-Or-Gatter 21 und ein Laufzeitglied 22 (enthält erforderlichenfalls auch einen Inverter), setzt das Binärsignal BS, dass die Zustände 0 und 1 aufweist, in ein vorcodiertes Duobinärsignal VDS nach der Funktion $b(t) = \overline{d}(t) \oplus b(t-1)$ um. Das als Coder verwendete Filter 4 erzeugt hieraus durch Überlagerung der binären Zustände ein Duobinärsinal EDS mit den Zuständen 0, 1 und 2. Durch die Ansteuerschaltung 51 werden diese Zustände in geeignete Ansteuersignale mit den Zuständen -1, 0, 1 umgesetzt, durch die beim Mach-Zehnder-Modulator 32 die Aussendung von 2 Signalwerten -1 und +1 veranlasst wird, die einen hohen Pegel und um 180˚ unterschiedliche Phasen aufweisen, sowie einen dritten Signalwert, bei dem der Pegel möglichst unterdrückt wird. Ein Empfänger 7 bewertet lediglich die Signalpegel, die von einem nachgeschalteten Decodierer 8 wiederum in das Binärsignal BS umgesetzt werden, dass am Datenausgang 9 abgegeben wird.

Der Sendeteil der bekannten Anordnung wird nun durch eine in **Figur 2** dargestellte erfindungsgemäße Anordnung ersetzt. Bei dieser Anordnung wird das vorcodierte Duobinärsignal VDS direkt dem optischen Modulator 5 zugeführt. Dieser enthält wiederum die Ansteuerschaltung 51 und den Mach-Zehnder-Modulator 52. Die Ansteuerschaltung bewirkt, dass der Mach-Zehnder-Modulator 52 ein phasenmoduliertes Signal PSK abgibt, dessen beide Zustände um 180˚ gegeneinander verschobene Phasen (-π/2, +π/2, praktischer 0 und π, usw.) aufweisen und symbolisch mit $-\dfrac{\pi}{2}$ und $+\dfrac{\pi}{2}$ bezeichnet sind. Die Umsetzung des phasenmodulierten Signals PSK in ein duobinäres Signal erfolgt jetzt durch das optische Filter 10, dass die Funktion $c(t) = c(t-1) + c(t)$ eines herkömmlichen Coders für Duobinärsignale realisiert. Die duobinäre Codierung erfolgt, indem im Filter ein entsprechend der Filterfunktion gespeicherter Signalwert (Bit) des vorcodierten Binärsignals vom aktuellen Signalwert entsprechend der Filterfunktion überlagert wird, wobei sich Zustände gleicher Phasenlage addieren und Zustände mit entgegengesetzter Phasenlage zu einer Auslöschung des Signals führen.

Die sorgfältige Dimensionierung des Filters ist daher für die Qualität des Duobinärsignals entscheidend. Besonders eignen sich hierfür Transversalfilter, die eine endliche Impulsantwort aufweisen, deren ideale Dauer (eines idealen Filters) (circa) zwei Bits beträgt bzw. die eine Einschwingdauer von (circa) zwei Bits aufweisen. Entsprechende Filterstrukturen können auf der Basis von planaren Lichtwellenleitern hergestellt werden. Diese sind beispielsweise von Koji Sasayama et al. "Coherent optical transversal filter using silica-based waveguides for highspeed signal processing" in IEEE-Journal of Lightwave Technology, Vol. 9, No. 10, October 1991 beschrieben. Ebenso können auch faseroptische Verzögerungsstrukturen eingesetzt werden, die auf einer inkohärenten Überlagerung des Lichts basieren. Diese sind von K. Jackson et al. in "Optical Fiber Delay-Line Signal Processing Transactions on Microwave Theory and Techniques, Vol. MTT-33, No. 3, pp. 193 - 210, March 1985 beschrieben. Auf die verwendeten Filter wird später noch genauer eingegangen.

Der wesentliche Vorteil der Duobinärcodierung mit optischen Filtern gegenüber der herkömmlichen mit einer Rechenschaltung besteht - wie bereits erwähnt - darin, dass eine Duobinärcodierung für mehrere WDM-Kanäle gleichzeitig mit nur einem einzigen optischen Filter vorgenommen werden kann. Grund dafür ist die strenge Periodizität der optischen Filter im Frequenzbereich. Wird diese so gewählt, dass sie dem Kanalabstand eines WDM-Systems entspricht, so kann insbesondere im System mit einer hohen Anzahl mit Kanälen eine simultane Duobinärcodierung durchgeführt werden, was eine erhebliche Aufwandseinsparung bedeutet.

In **Figur 3** ist ein DWDM-System dargestellt. Vier Precoder-Modulator-Einrichtungen 3-1, 3-3, 3-5, 3-7, denen jeweils ein Binärsignal BS1, BS3, BS5, BS7 zugeführt wird, erzeugen jeweils ein phasenmoduliertes Signal PSK1, PSK3, PSK5, PSK7. Diese Signale werden in einem ersten optischen Multiplexer 11 zu einer Gruppe, einem ersten Multiplex-PSK-Signal, PSK1,3,5,7 zusammengefasst. Der Ausgang dieses optischen Multiplexers ist mit einem ersten optischen Filter 13 verbunden, dass simultan für alle Signale PSK1, PSK3, PSK5, PSK7 der Gruppe eine Duobinärcodierung durchführt und eine Gruppe ODS1,3,5,7 duobinär codierter Signale, das heißt ein Multiplex-Duobinärsignal, abgibt. Entsprechend werden weitere Binärsignale BS2, BS4, BS6, BS8 in weiteren Precoder-Modulator-Einrichtungen 3-2, 3-4, 3-6, 3-8 in phasenmodulierte Signale PSK2, PSK4, PSK6, PSK8 umgesetzt, die durch einen zweiten optischen Multiplexer 12 zusammengefasst und durch ein zweites optisches Filter in eine zweite Gruppe ODS2,4,6,8 Duobinärsignale, d. h. ein zweites Multiplex-Duobinärsignal, umgesetzt. Durch die Duobinärcodierung wird Bandbreite der einzelnen Signale jedes duobinären Multiplexsignals halbiert, so dass diese problemlos über einen Koppler 15 zu einem duobinärcodierten Dense-Multiplexsignal DODS zusammengefasst werden können, das am Sendeausgang 16 abgegeben wird.

In **Figur 4** ist das Prinzipschaltbild eines geeigneten optischen Transversalfilters dargestellt. Für ein Übertragungssystem mit 40 Gbit/s betragen die Verzögerungszeiten der Laufzeitglieder 18 bis 21 jeweils 10 Picosekunden und die fünf Koeffizienten des Filters 13 betragen 0,33; 0,79; 1; 0,79; 0,33, wodurch eine ideale Filterfunktion bereits ausreichend genau nachgebildet wird. Die durch Interpolation erhaltene idealisierte Impulsantwort hat die Dauer von 50 Picosekunden. Die Koeffizienten K1 - K5 beinhalten bereits die Dämpfung durch die einzelnen Koppler. Die Koeffizienten des zweiten optischen Filters betragen 0,33; -0,79; 1; -0,79; 0,33. Die negativen Koeffizienten werden durch Verschieben der Phase des optischen Signals durch Einstellen der Verzögerungsglieder realisiert. Wie beim herkömmlichen Transversalfilter werden die mit den Koeffizienten bewerteten Signale in einem Koppler-Addierer 22 zusammengefasst und am Filterausgang 23 abgegeben, wobei die durch mit einem negativen Koeffizienten multiplizierten Signalanteile gegenphasig sind und daher subtrahiert werden.

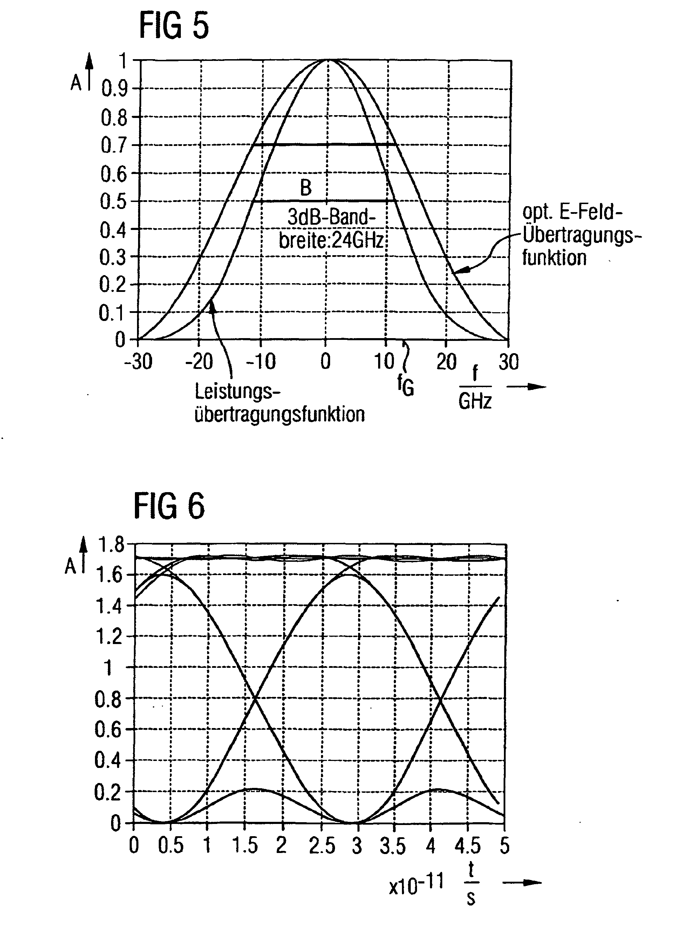

Das Filter 14 weist eine in **Figur 5** dargestellte Übertragungsfunktion (Betragsfrequenzgang), die Ausgangsamplitude A als Funktion der Frequenz f in Hz (1/s), auf. Bei der Dimensionierung des Filters wird der Einfuß der anderen Schaltungskomponenten mit berücksichtigt. Wird bei einem 40 Gbit/s-System elektrischen Tiefpaß zur Codierung verwendet, würde man die Grenzfrequenz $f_G$ (3 dB-Frequenz) von einem Viertel der Bitrate wählen, hier 10 GHz, da der nachgeschaltete Mach-Zehnder-Modulator das Spektrum wieder verbreitert. Bei einem optischen Filter wird eine etwas höhere Grenzfrequenz von etwa 12 GHz (10,5 bis 13,5 GHz) bzw. Bandbreite B = 24 GHz gewählt. Es wird ein cosinusförmiger Verlauf der Übertragungsfunktion wegen des daraus resultierenden günstigen Einschwingverhaltens angestrebt. Die erste Nullstelle liegt hier bei 30 GHz.

**Figur 6** zeigt ein ohne Empfangsfilter aufgenommenes Augendiagramm, die Amplitude A als Funktion der Zeit t in Sekunden bei einer kurzen Übertragungsstrecke.

Mit Hilfe dieser Methode können auch bisherige WDM-Systeme zu DWDM-Systemen aufgerüstet werden.

**Patentansprüche**

1. Verfahren zur Duobinärcodierung einer Gruppe von Binärsignalen (BS1, BS3, BS5, BS7), **dadurch gekennzeichnet,** **dass** jedes Binärsignal der Gruppe von Binärsignalen (BS1, BS3, BS5, BS7) im elektrischen Bereich in ein duobinär vorcodiertes, Binärsignal (VDS) umgesetzt wird, und dann jedes derart duobinär vorcodierte Binärsignal (VDS) in ein phasenmoduliertes optisches Signal (PSK1, PSK3, PSK5, PSK7) mit zwei um $\pi$ gegeneinander phasenverschobenen Zuständen (-$\pi$/2, +$\pi$/2) umgesetzt wird, **dass** die phasenmodulierten optischen Signale (PSK1, PSK3, PSK5, PSK7) zu einer Gruppe (PSK1,3,5,7) phasenmodulierter Signale zusammengefasst werden, die einem periodischen optischen Filter (13) zugeführt wird, das als Coder simultan die Gruppe (PSK1,3,5,7) phasenmodulierter optischer Signale (PSK1, PSK3, PSK5, PSK7) in eine Gruppe Duobinärsignale (ODS1,3,5,7) umsetzt.

2. Verfahren nach Anspruch 1 **dadurch gekennzeichnet,** **dass** m Gruppen von Binärsignalen (BS1, BS3, BS5, BS7; BS2, BS4, BS6, BS8) in m Gruppen (PSK1,3,5,7; PSK2,4,6,8) phasenmodulierter Signale umgesetzt werden, wobei die phasenmodulierte Signale einer Gruppe gleiche Frequenzabstände aufweisen, aber um 1/m ihres Frequenzabstandes oder einem Vielfachen hiervon gegenüber den phasenmodulierten Signalen anderer Gruppen versetzt sind, dass die m Gruppen phasenmodulierter Signale (PSK1,3,5,7; PSK2,4,6,8) in m Gruppen Duobinärsignale (ODS1,3,5,7; ODS 2,4,6,8) umgesetzt werden und dass anschließend die m Gruppen Duobinärsignale (MDS1,3,5,7; MDS 2,4,6,8) zu einem Dense-Multiplex-Duobinärsignal (DODS) zusammengefasst werden.

3. Verfahren nach Anspruch 1, **dadurch gekennzeichnet,** **dass** zwei Gruppen von Duobinärsignalen (ODS1,3,5,7; ODS 2,4,6,8) zu einem Dense-Multiplex-Duobinärsignal (DODS) zusammengefasst werden.

4. Verfahren nach einem der vorhergehenden Ansprüche, **dadurch gekennzeichnet,** **dass** die Umsetzung eines phasenmodulierten Signals (PSK) in ein Duobinärsignal (ODS)oder die Umsetzung einer Gruppe phasenmodulierter Signale (PSK1,3,5,7) in eine Gruppe Duobinärsignale (ODS1,3,5,7) durch ein Filter (10; 13; 14) mit einem cosinusförmigen Verlauf der Übertragungsfunktion erfolgt, dessen idealisierte Impulsantwort bei zwei Bitlängen des Binärsignals (BS) liegt.

5. Anordnung zur Duobinärcodierung einer Gruppe von Binärsignalen (BS1, BS3, BS5, BS7) mit einem Precoder (2), einem Filter als Coder und einem Phasenmodulator (5),
**dadurch gekennzeichnet,**
**dass** mehrere, jeweils einen Precoder (2) und einen Phasenmodulator (52) aufweisende Precoder-Modulator-Einrichtungen (3-1, 3-3, 3-5, 3-7) vorgesehen sind, deren Eingängen Binärsignale (BS1, BS3, BS5, BS7) zugeführt werden, die in phasenmodulierte optische Signale (PSK1, PSK3, PSK5, PSK7) umgesetzt werden,
**dass** Ausgänge der Precoder-Modulator-Einrichtungen (3-1, 3-3, 3-5, 3-7) mit einem Wellenlängen-Multiplexer (11) verbunden sind, der die phasenmodulierten optischen Signale (PSK1, PSK3, PSK5, PSK7) zu einer Gruppe (PSK1,3,5,7) phasenmodulierter optischer Signale zusammenfasst, und **dass** an den Ausgang des Wellenlängen-Multiplexers (11) ein periodisches optisches Filter (13) angeschaltet ist, das als Coder simultan die Gruppe (PSK1,3,5,7) phasenmodulierter optischer Signale in eine Gruppe (ODS) Duobinärsignale umsetzt.

6. Anordnung nach Anspruch 5,
**dadurch gekennzeichnet,**
**dass** m Wellenlängen-Multiplexer vorgesehen sind, die jeweils eine Gruppe phasenmodulierter optischer Signale (PSK1,3,5,7; PSK2,4,6,8) an ihren Ausgängen abgeben, wobei die Mittenfrequenzen der Wellenlängen-Multiplexer gegeneinander versetzt sind,
**dass** an den Ausgang jedes Multiplexers (11, 12) ein optisches Filter (13, 14) zur Erzeugung einer Gruppe (ODS1,3,5,7; ODS2,4,6,8) optischer Duobinärsignale angeschaltet ist und **dass** die Ausgänge der Filter (13, 14) an einen Koppler (16) oder ein Filter geführt sind, um die m Gruppen (ODS1,3,5,7; ODS2,4,6,8) optischer Duobinärsignale zusammenzufassen.

7. Anordnung nach einem der Ansprüche 5 oder 6,
**dadurch gekennzeichnet,**
**dass** als optisches Filter (13, 14) ein Transversalfilter vorgesehen ist.

8. Anordnung nach Anspruch 7,
**dadurch gekennzeichnet,**
**dass** die Übertragungsfunktion des optischen Filters (13, 14) einen cosinusförmigen Verlauf aufweist und die Dauer der idealisierten Impulsantwort bei zwei Bitlängen des Binärsignals (BS) liegt.

**Claims**

1. Method for duobinary coding of a group of binary signals (BS1, BS3, BS5, BS7),
**characterized**
**in that** each signal $\overline{d}(t)$ (BS1, BS3, BS5, BS7) in the group of binary signals (BS1, BS3, BS5, BS7) is duobinary-precoded in the electrical area according to the function $b(t) = \overline{d}(t) \oplus b(t\text{-}1)$, and then each duobinary-precoded signal $b(t)$ (VDS) is converted to a phase-modulated optical signal (PSK1, PSK3, PSK5, PSK7) in which the binary values correspond to two optical signal values which are phase-shifted through $\pi$ with respect to one another ($-\pi/2$, $+\pi/2$), and
**in that** the phase-modulated optical signals are combined to form a group (PSK1,3,5,7) of phase-modulated optical signals, which are supplied to a periodic optical filter (13) which, as a coder, simultaneously converts the group (PSK1,3,5,7) of phase-modulated optical signals (PSK1, PSK3, PSK5, PSK7) to a group of optical duobinary signals (ODS1,3,5,7).

2. Method according to Claim 1,
**characterized**
**in that** m groups of binary signals (BS1, BS3, BS5, BS7; BS2, BS4, BS6, BS8) are converted to m groups (PSK1,3,5,7; PSK2,4,6,8) of phase-modulated signals with the phase-modulated signals in one group having the same frequency separations, but being offset by 1/m of their frequency separation, or a multiple thereof, with respect to the phase-modulated signals in other groups, and
**in that** the m groups of phase-modulated signals (PSK1,3,5,7; PSK2,4,6,8) are converted to m groups of optical duobinary signals (ODS1,3,5,7; ODS2,4,6,8), and in that the m groups of optical duobinary signals (MDS1,3,5,7; MDS2,4,6,8) are then combined to form a dense multiplex duobinary signal (DODS).

3. Method according to Claim 1,
**characterized**
**in that** two groups of duobinary signals (ODS1,3,5,7; ODS2,4,6,8) are combined to form a dense multiplex duobinary signal (DODS).

4. Method according to one of the preceding claims,
**characterized**
**in that** the conversion of a phase-modulated signal (PSK) to a duobinary signal (ODS) or the conversion of a group of phase-modulated signals (PSK1,3,5,7) to a group of duobinary signals (ODS1,3,5,7) is carried out by means of a filter (10; 13; 14) whose transfer function has a cosine profile and whose idealized impulse response occurs at twice the bit length of the binary signal (BS).

**5.** Arrangement for duobinary coding of a group of optical binary signals (BS1, BS3, BS5, BS7) having a precoder (2), a filter as a coder, and a phase modulator (5), **characterized in that** a number of precoder modulator devices (3-1, 3-3, 3-5, 3-7) are provided, which each have a precoder (2) and a phase modulator (52) and to whose inputs binary signals (BS1, BS3, BS5, BS7) are supplied, which convert the binary signals (BS1, BS3, BS5, BS7) to phase-modulated optical signals (PSK1, PSK3, PSK5, PSK7), and whose outputs are connected to a wavelength division multiplexer (11), which combines the phase-modulated optical signals (PSK1, PSK3, PSK5, PSK7) to form a group (PSK1,3,5,7) of phase-modulated optical signals, and **in that** a periodic optical filter (13) is connected to the output of the wavelength division multiplexer (11), which, as a coder, simultaneously converts the group (PSK1,3,5,7) of phase-modulated optical signals to a group (ODS1,3,5,7) of optical duobinary signals.

**6.** Arrangement according to Claim 5, **characterized in that** m wavelength division multiplexers are provided, each of which emits a group of phase-modulated optical signals (PSK1,3,5,7; PSK2,4,6,8) at its outputs, with the mid-frequencies of the wavelength division multiplexers being offset with respect to one another, **in that** an optical filter (13, 14) for producing a group (ODS1,3,5,7; ODS2,4,6,8) of optical duobinary signals is connected to the output of each multiplexer (11, 12), and **in that** the outputs of the filters (13, 14) are passed to a coupler (16) or to a filter, in order to combine the m groups (ODS1,3,5,7; ODS2,4,6,8) of optical duobinary signals.

**7.** Arrangement according to one of Claims 5 or 6, **characterized in that** a transversal filter is provided as the optical filter (13, 14).

**8.** Arrangement according to Claim 7, **characterized in that** the transfer function of the optical filter (13, 14) has a cosine profile, and the duration of the idealized impulse response occurs at twice the bit length of the binary signal (BS).

**Revendications**

**1.** Procédé de codage duobinaire d'un groupe de signaux binaires (BS1, BS3, BS5, BS7)

**caractérisé en ce que** chaque signal $\overline{d}$(t) (BS1, BS3, BS5, BS7) du groupe de signaux binaires (BS1, BS3, BS5, BS7) est précodé en duobinaire dans le domaine électrique selon la fonction b(t) = $\overline{d}$(t)⊕b(t-1) et chaque signal précodé en duobinaire b(t) (VDS) est ensuite converti en un signal optique modulé en phase (PSK1, PSK3, PSK5, PSK7), dans lequel les valeurs binaires correspondent à deux valeurs de signal optique déphasées l'une par rapport à l'autre de π (-π/2, +π/2), **en ce que** les signaux optiques modulés en phase sont réunis en un groupe (PSK1, 3, 5, 7) de signaux optiques modulés en phase, lequel est amené à un filtre optique périodique (13) qui en tant que codeur convertit simultanément le groupe (PSK1, 3, 5, 7) de signaux optiques modulés en phase (PSK1, PSK3, PSK5, PSK7) en un groupe de signaux optiques duobinaires (ODS1, 3, 5, 7).

**2.** Procédé selon la revendication 1, **caractérisé en ce que** m groupes de signaux binaires (BS1, BS3, BS5, BS7 ; BS2, BS4, BS6, BS8) sont convertis en m groupes (PSK1, 3, 5, 7 ; PSK2, 4, 6, 8) de signaux modulés en phase, les signaux modulés en phase d'un groupe présentant les mêmes écarts de fréquence mais étant décalés de 1/m de leur écart de fréquence ou d'un multiple de celui par rapport aux signaux modulés en phase d'autres groupes, **en ce que** les m groupes de signaux modulés en phase (PSK1, 3, 5, 7 ; PSK2, 4, 6, 8) sont convertis en m groupes de signaux optiques duobinaires (ODS1, 3, 5, 7 ; ODS2, 4, 6, 8) et **en ce que** les m groupes de signaux optiques duobinaires (MDS1, 3, 5, 7 ; MDS2, 4, 6, 8) sont ensuite réunis en un signal duobinaire de multiplexage dense (DODS).

**3.** Procédé selon la revendication 1, **caractérisé en ce que** deux groupes de signaux duobinaires (ODS1, 3, 5, 7 ; ODS2, 4, 6, 8) sont réunis en un signal duobinaire de multiplexage dense (DODS).

**4.** Procédé selon l'une des revendications précédentes, **caractérisé en ce que** la conversion d'un signal modulé en phase (PSK) en un signal duobinaire (ODS) ou la conversion d'un groupe de signaux modulés en phase (PSK1, 3, 5, 7) en un groupe de signaux duobinaires (ODS1, 3, 5, 7) est effectuée par un filtre (10; 13; 14) avec une allure cosinusoïdale de la fonction de transfert et dont la réponse impulsionnelle idéalisée est de l'ordre de deux longueurs de bit du signal binaire (BS).

**5.** Arrangement de codage duobinaire d'un groupe de signaux optiques binaires (BS1, BS3, BS5, BS7), comprenant un précodeur (2), un filtre en tant que codeur et un modulateur de phase (5),
**caractérisé en ce que**
plusieurs dispositifs précodeurs-modulateurs (3-1, 3-3, 3-5, 3-7) comprenant chacun un précodeur (2) et un modulateur de phase (52) sont prévus, aux entrées desquels sont amenés des signaux binaires (BS1, BS3, BS5, BS7), qui convertissent les signaux binaires (BS1, BS3, BS5, BS7) en signaux optiques modulés en phase (PSK1, PSK3, PSK5, PSK7) et dont les sorties sont reliées à un multiplexeur en longueur d'onde (11) qui réunit les signaux optiques modulés en phase (PSK1, PSK3, PSK5, PSK7) en un groupe (PSK1, 3, 5, 7) de signaux optiques modulés en phase,
**en ce qu'**un filtre optique périodique (13) est branché sur la sortie du multiplexeur en longueur d'onde (11), qui en tant que codeur convertit simultanément le groupe (PSK1, 3, 5, 7) de signaux optiques modulés en phase en un groupe (ODS1, 3, 5, 7) de signaux optiques duobinaires.

6. Arrangement selon la revendication 5,
**caractérisé en ce que**
m multiplexeurs en longueur d'onde sont prévus, qui délivrent chacun un groupe de signaux optiques modulés en phase (PSK1, 3, 5, 7 ; PSK2, 4, 6, 8) à leurs sorties, les fréquences médianes des multiplexeurs en longueur d'onde étant décalées les unes par rapport aux autres,
**en ce qu'**un filtre optique (13, 14) destiné à produire un groupe (ODS1, 3, 5, 7) de signaux optiques duobinaires est branché sur la sortie de chaque multiplexeur (11, 12) et
**en ce que** les sorties des filtres (13, 14) sont amenées à un coupleur (16) ou un filtre pour réunir les m groupes (ODS1, 3, 5, 7 ; ODS2, 4, 6, 8) de signaux optiques duobinaires.

7. Arrangement selon l'une des revendications 5 ou 6,
**caractérisé en ce que**
un filtre transversal est prévu comme filtre optique (13, 14).

8. Arrangement selon la revendication 7,
**caractérisé en ce que**
la fonction de transfert du filtre optique (13, 14) présente une allure cosinusoïdale et que la durée de la réponse impulsionnelle idéalisée est de l'ordre de deux longueurs de bit du signal binaire (BS).

FIG 1

FIG 2

## FIG 3

BS1 →/ 3-1 [ 193.00THz ] —PSK1→

BS2 →/ 3-2 [ 193.05THz ] —PSK2→

BS3 →/ 3-3 [ 193.10THz ]

BS4 →/ 3-4 [ 193.15THz ] —PSK4→

BS5 →/ 3-5 [ 193.20THz ] —PSK5→

BS6 →/ 3-6 [ 193.25THz ] —PSK6→

BS7 →/ 3-7 [ 193.30THz ] —PSK7→

BS8 →/ 3-8 [ 193.35THz ] —PSK8→

PSK3→

11

PSK→ [13] ODS 1,3,5,7

PSK 1,3,5,7

12

PSK 2,4,6,8 [14] ODS 2,4,6,8

15 → DODS

16

## FIG 4

PSK→

18  19  20  21

⊗ K1   ⊗ K2   ⊗ K3   ⊗ K4   ⊗ K5

+   22

↓ ODS

23

## FIG 5

## FIG 6